(19) Europäisches Patentamt
European Patent Office
Office européen des brevets

(11) **EP 2 637 027 B1**

(12) **FASCICULE DE BREVET EUROPEEN**

(45) Date de publication et mention
de la délivrance du brevet:
**03.04.2019 Bulletin 2019/14**

(51) Int Cl.:
***G01R 15/20*** *(2006.01)*

(21) Numéro de dépôt: **13156591.3**

(22) Date de dépôt: **25.02.2013**

(54) **PROCEDE ET DISPOSITIF DE MESURE DE COURANT DANS UN RESEAU ELECTRIQUE**

VERFAHREN UND ANORDNUNG ZUR STROMMESSUNG IN EINEM ELEKTRISCHEN NETZWERK.

METHOD AND APPARATUS FOR MEASURING CURRENT IN AN ELECTRIC NETWORK

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **05.03.2012 FR 1251967**

(43) Date de publication de la demande:
**11.09.2013 Bulletin 2013/37**

(73) Titulaire: **Smartfuture**
**83390 Pierrefeu du Var (FR)**

(72) Inventeur: **Bertrand, Paul**
**833940 Pierrefeu du Var (FR)**

(74) Mandataire: **Marchand, André et al**
**OMNIPAT**
**24 Place des Martyrs de la Résistance**
**13100 Aix-en-Provence (FR)**

(56) Documents cités:
**WO-A1-01/50142      WO-A2-2012/003492
US-B1- 6 304 082**

**Description**

La présente invention concerne un procédé de mesure de courant dans un réseau électrique. La mesure de consommation de courant dans un réseau électrique permet d'établir un diagnostic énergétique. En offrant à l'usager la possibilité de surveiller sa consommation électrique poste par poste, dite "usage électrique", on peut lui permettre de réaliser des économies importantes.

De nouvelles réglementations thermiques encouragent l'emploi de dispositifs de mesure de consommation électrique dans les bâtiments tertiaires et résidentiels, en prévoyant, dans chaque tableau électrique, une estimation et l'affichage des consommations des divers équipements connectés (chauffage, refroidissement, production d'eau chaude, éclairage, cuisson, prises de courant, etc.).

On connaît plusieurs méthodes permettant d'estimer les usages électriques. Certaines méthodes consistent en une mesure directe par installation d'un sous-compteur d'usage dans le tableau électrique, d'autres consistent dans une mesure indirecte par analyse de la courbe de charge globale sur le réseau, et corrélation avec des paramètres d'usage des divers dispositifs connectés.

Les méthodes indirectes fournissent une estimation des usages par analyse de la courbe de charge au point d'entrée du tableau électrique. Elles présentent un champ d'application réduit, limité aux charges qui commutent un faible nombre de fois dans une journée. Elles utilisent un algorithme d'estimation par corrélation qui est peu fiable lorsque les charges présentent une consommation électrique qui varie de manière continue, par exemple un climatiseur, une pompe à chaleur ou un moteur à commande variable, ou qui commutent très souvent avec des intervalles de temps de quelques secondes. Ces méthodes sont donc difficilement applicables au secteur tertiaire ou aux commerces.

Les méthodes par mesure directe nécessitent l'installation dans le tableau électrique de modules de sous-comptage comprenant chacun un capteur de courant, devant être agencés en série avec les disjoncteurs de protection. On a également proposé des disjoncteurs qui incorporent des moyens de mesure de courant.

Les méthodes par mesure directe sont d'une mise en oeuvre complexe et coûteuse lorsqu'elles doivent être mises en oeuvre dans une installation existante. En effet, il est dans ce cas nécessaire de modifier le câblage du tableau électrique, voire de changer le tableau afin de permettre l'installation des modules de sous-comptage ou de nouveaux disjoncteurs. Le coût de l'installation dépasse alors largement l'enjeu économique pour le particulier, un petit commerce ou un petit bâtiment tertiaire. Cette méthode est donc rarement mise en oeuvre.

WO 2012/003492 décrit l'utilisation d'un magnétomètre à effet Hall, agencé à proximité d'un faisceau de fils de tableau électrique, pour mesurer le courant global traversant le tableau électrique.

Pour réduire le prix de revient des modules de comptage, on a proposé des disjoncteurs équipés d'un capteur de courant à système microélectromécanique ou MEMS (Microelectromechanical systems), tel que décrit par exemple dans le document WO 2008 042 483. Néanmoins, les disjoncteurs conventionnels restent généralement préférés en raison de leur faible prix de revient. De plus, les disjoncteurs équipés de capteurs de courant concernent le marché du neuf et ne trouvent aucun débouché dans les bâtiments existants du fait de leurs coûts d'achat et d'installation importants.

Le document WO 0150142 décrit également des modules de comptage à partir de capteurs MEMS qui sont agencés autour des fils électriques. Ces capteurs doivent être reliés à un circuit électronique de mesure et le prix de revient de l'ensemble est élevé.

Il pourrait donc être souhaité de prévoir un procédé de mesure de courant dans un réseau électrique qui soit d'un prix de revient réduit et facilement adaptable à une installation électrique existante, sans nécessiter de remplacer les éléments qu'elle comporte.

Des modes de réalisation de l'invention concernent un procédé de mesure de courant dans un réseau électrique, comprenant au moins une première ligne électrique, comprenant les étapes consistant à relier la première ligne électrique à un premier disjoncteur comprenant une première bobine de protection et présentant une paroi traversée par un champ magnétique émis par la bobine; agencer sur la paroi du premier disjoncteur un premier magnétomètre numérique triaxial synchrone sur microplaquette de semi-conducteur; au moyen du premier magnétomètre numérique, mesurer au moins une composante du champ magnétique émis par la première bobine; et déterminer la valeur d'un courant traversant la ligne électrique à partir de la composante mesurée.

Selon un mode de réalisation, le procédé comprend une étape consistant à agencer autour du magnétomètre un blindage magnétique pour limiter l'influence sur le magnétomètre d'un champ magnétique émis par un disjoncteur voisin.

Selon un mode de réalisation, le procédé comprend les étapes consistant à relier au moins une seconde ligne électrique à un second disjoncteur comprenant une seconde bobine de protection présentant une paroi traversée par un champ magnétique émis par la seconde bobine; agencer sur la paroi du second disjoncteur un second magnétomètre numérique triaxial synchrone sur microplaquette de semi-conducteur; au moyen du second magnétomètre, mesurer au moins une composante d'un champ magnétique émis par la première bobine; corriger les composantes mesurées par chaque magnétomètre en retranchant à chaque composante une fraction de la composante mesurée par l'autre magnétomètre, afin de neutraliser un phénomène d'interférence magnétique entre les deux disjoncteurs; et déterminer la valeur d'un courant traversant chaque ligne électrique à partir des composantes corrigées.

Selon un mode de réalisation, l'étape de correction comprend une étape de détermination, pour chaque disjoncteur, d'un paramètre d'interférence du disjoncteur sur un magnétomètre associé à un autre disjoncteur, représentatif d'une variation du champ magnétique détecté par le magnétomètre associé à l'autre disjoncteur, lorsque le champ magnétique émis par le disjoncteur varie.

Selon un mode de réalisation, le procédé comprend une étape de détermination d'une matrice d'interférence incluant l'ensemble des paramètres d'interférence, une étape de détermination d'une matrice inverse de la matrice d'interférence, et une étape de correction des composantes mesurées à partir de la matrice d'interférence inversée.

Selon un mode de réalisation, l'étape de détermination du paramètre d'interférence comprend les étapes suivantes : échantillonner de manière synchrone, à deux instants successifs, une composante du champ magnétique mesurée par le premier magnétomètre et une composante du champ magnétique mesurée par le second magnétomètre, déterminer une variation de la première composante et une variation de la seconde composante, et déterminer le paramètre d'interférence d'un disjoncteur sur le magnétomètre associé à l'autre disjoncteur en divisant la plus petite des deux variations en valeur absolue par la plus grande des deux variations en valeur absolue.

Selon un mode de réalisation, le procédé comprend une étape d'étalonnage de chaque magnétomètre pour associer à une valeur de champ magnétique alternatif mesurée une valeur de courant circulant dans la ligne électrique correspondante.

Selon un mode de réalisation, la mesure d'une composante d'un champ magnétique émis par la bobine d'un disjoncteur comprend une étape de suppression d'une composante continue de champ magnétique terrestre.

Des modes de réalisation de l'invention concernent également un dispositif de mesure de courant dans un réseau électrique, comprenant au moins un premier disjoncteur relié à une première ligne électrique, comprenant une première bobine de protection et présentant une paroi traversée par un champ magnétique émis par la bobine; un premier magnétomètre numérique triaxial synchrone sur microplaquette de semi-conducteur, agencé sur la paroi du premier disjoncteur; et un circuit de contrôle et de traitement, pour mesurer au moyen du premier magnétomètre au moins une composante du champ magnétique émis par la première bobine, et déterminer la valeur d'un courant traversant la ligne électrique à partir de la composante mesurée.

Selon un mode de réalisation, le dispositif comprend un blindage magnétique agencé autour du magnétomètre pour limiter l'influence sur le magnétomètre d'un champ magnétique émis par un disjoncteur voisin.

Selon un mode de réalisation, le dispositif comprend au moins un second disjoncteur relié à une seconde ligne électrique, comprenant une seconde bobine de protection et présentant une paroi traversée par un champ magnétique émis par la seconde bobine, un second magnétomètre numérique triaxial synchrone sur microplaquette de semi-conducteur, agencé sur la paroi du second disjoncteur, et relié au circuit de contrôle et de traitement, le circuit de contrôle et de traitement étant configuré pour corriger les composantes mesurées par chaque magnétomètre en retranchant à chaque composante une fraction de la composante mesurée par l'autre magnétomètre, afin de neutraliser un phénomène d'interférence magnétique entre les deux disjoncteurs, et déterminer la valeur d'un courant traversant chaque ligne électrique à partir des composantes corrigées.

Selon un mode de réalisation, le circuit de contrôle et de traitement est configuré pour déterminer, pour chaque disjoncteur, un paramètre d'interférence du disjoncteur sur un magnétomètre associé à un autre disjoncteur, représentatif d'une variation du champ magnétique détecté par le magnétomètre associé à l'autre disjoncteur, lorsque le champ magnétique émis par le disjoncteur varie.

Selon un mode de réalisation, le circuit de contrôle et de traitement est configuré pour échantillonner de manière synchrone, à deux instants successifs, une composante du champ magnétique mesurée par le premier magnétomètre et une composante du champ magnétique mesurée par le second magnétomètre, déterminer une variation de la première composante et une variation de la seconde composante, et déterminer le paramètre d'interférence d'un disjoncteur sur le magnétomètre associé à l'autre disjoncteur en divisant la plus petite en valeur absolue des deux variations par la plus grande des deux variations en valeur absolue.

Selon un mode de réalisation, le dispositif comprend un module de mesure comprenant un boîtier configuré pour être agencé sur la paroi d'un disjoncteur, un support d'interconnexion recevant un magnétomètre, et des moyens de couplage électrique du magnétomètre à au moins un autre magnétomètre agencé dans un autre module de mesure.

Des modes de réalisation de l'invention concernent également un système de gestion de la consommation électrique dans un réseau électrique comprenant des lignes électriques, comprenant un dispositif de mesure selon l'invention, et un dispositif de gestion déporté configuré pour mémoriser des valeurs de courant fournies par le dispositif de mesure.

Des modes de réalisation d'un procédé et d'un dispositif de mesure de courant selon l'invention seront décrits dans ce qui suit à titre non limitatif, en relation avec les figures jointes parmi lesquelles :

- la figure 1 montre un magnétomètre numérique triaxial du commerce,
- la figure 2 montre la structure du magnétomètre,

- la figure 3 est une vue en coupe d'un disjoncteur classique équipé du magnétomètre,
- la figure 4 montre des modules de mesure de courant selon l'invention,
- les figures 5A, 5B sont des vues en perspective et de profil d'un ensemble de disjoncteurs recevant les modules de mesure de courant,
- la figure 6 est le schéma électrique d'un dispositif de mesure de courant comprenant les modules de mesure,
- la figure 7 illustre une étape d'un procédé de correction d'interférence selon l'invention, et
- la figure 8 montre une variante d'un module de mesure de courant selon l'invention.

La présente invention inclut l'observation selon laquelle il existe, sur le marché, des magnétomètres numériques triaxiaux conçus pour mesurer le champ magnétique terrestre et destinés au marché des téléphones mobiles, pour des applications de type boussole logicielle, détecteur de métal, analyseur d'argent pur, etc.

Ces magnétomètres à base de MEMS (systèmes microélectromécaniques) sont intégrés sur une puce de semi-conducteur et comportent, en sus de capteurs du champ magnétique terrestre, un circuit de mesure et de contrôle et un circuit d'interface de communication apte à dialoguer avec un contrôleur externe par l'intermédiaire d'un bus de données.

En raison des larges quantités commercialisées, ces magnétomètres sont d'un prix de revient très faible, et très largement inférieur à celui d'un détecteur de champ magnétique et son circuit électronique de mesure associé, du type monté dans les tableaux électriques pour mesurer un courant.

De tels magnétomètres peuvent, par ailleurs, effectuer des mesures synchrones grâce à une entrée de synchronisation pouvant recevoir un signal de synchronisation externe.

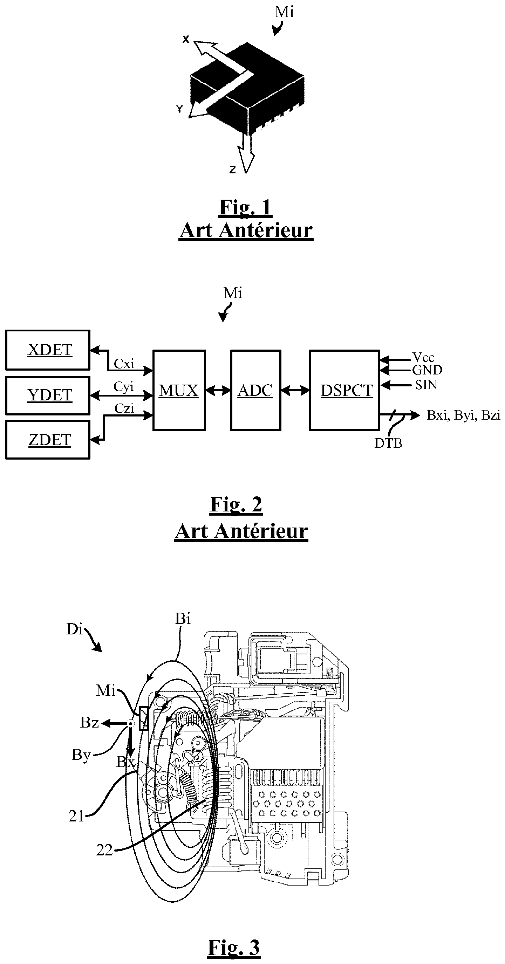

La figure 1 représente à titre d'exemple le boîtier d'un tel magnétomètre numérique triaxial Mi et la figure 2 représente le schéma électrique du magnétomètre Mi. Il s'agit par exemple du magnétomètre commercialisé par la société Freescale sous la référence MAG3110. Le boîtier présente une faible surface, typiquement de l'ordre de 3 mm x 3 mm.

Le magnétomètre Mi est capable de mesurer un champ magnétique avec une fréquence allant jusqu'à 80 Hz, correspondant à un intervalle d'échantillonnage d'environ 12 ms. Il comporte un étage de détection équipé de trois capteurs XDET, YDET, et ZDET configurés pour mesurer le champ magnétique terrestre selon trois axes orthogonaux X, Y, et Z et fournir des signaux analogiques de mesure $C_{xi}$, $C_{yi}$, $C_{zi}$. Il comporte également un multiplexeur MUX reliant les capteurs à un convertisseur analogique/numérique ADC, dont la sortie fournit des signaux de capteurs numérisés $DC_x$, $DC_y$, $DC_z$ à un circuit de contrôle et de traitement DSPCT. Le circuit DSPCT est configuré pour fournir, par l'intermédiaire d'une sortie compatible avec un bus de données DTB (par exemple un bus I2C à deux fils dans le cas du magnétomètre MAG3110), des composantes de champ magnétique $B_{xi}$, $B_{yi}$, $B_{zi}$. Le circuit DSPCT comprend également une entrée de synchronisation SIN, (par exemple le contact INT1 dans la documentation du magnétomètre MAG3110). Il comporte également des contacts d'alimentation Vcc et GND (masse) et divers autres contacts qui ne seront pas détaillés ici.

Un tel magnétomètre, en raison de sa présentation sous forme de micro-boîtier et les applications pour lesquelles il a été conçu, est conventionnellement jugé impropre à une mesure de courant dans une ligne électrique. Des études ont montré notamment que sa sensibilité n'est pas suffisante pour une mesure fiable du champ magnétique à proximité d'un fil électrique soumis à un courant d'intensité moyenne représentatif de la consommation électrique dans une branche d'un réseau électrique domestique.

On constate toutefois que sa fréquence de mesure maximale de 80 Hz le rend apte à échantillonner de manière synchrone un champ magnétique alternatif oscillant, notamment un champ oscillant à 50 Hz ou 60 Hz généré par un courant alternatif du réseau électrique. Un tel échantillonnage ne sera pas conforme au théorème de Nyquist-Shannon, ce qui peut entraîner une erreur dans l'estimation de la valeur du signal oscillant à 50 ou 60 Hz. Une telle erreur peut toutefois être tolérée dans le cadre de l'estimation du courant passant dans une ligne électrique, qui ne nécessite pas une précision métrologique. Par ailleurs, un magnétomètre du type précité mais présentant une fréquence d'échantillonnage plus élevée est susceptible d'être mis sur le marché à l'avenir, et pourra alors être retenu pour la mise en oeuvre de l'invention.

La présente invention inclut également l'observation selon laquelle, dans les tableaux électriques actuels, des disjoncteurs magnétothermiques sont généralement utilisés à la place des fusibles conventionnels. La figure 3 représente la structure classique d'un disjoncteur magnétothermique Di. Le disjoncteur comprend un levier de réarmement 21, un organe de disjonction thermique et un organe de disjonction magnétique. Ces organes sont connus et ne seront pas décrits en détail ici. L'organe de disjonction magnétique comporte un solénoïde, ou bobine de protection 22. Une fois monté sur un tableau électrique, le disjoncteur Di est traversé par le même courant que celui qui traverse la ligne à surveiller, et ce courant passe également à travers la bobine de protection 22.

La bobine de protection 22 génère un champ magnétique Bi proportionnel au courant qui la traverse. Lorsque la ligne électrique en aval du disjoncteur présente un court-circuit, le courant dépasse un certain seuil et le champ magnétique devient alors suffisamment important pour provoquer le déclenchement du disjoncteur.

Des études ont été conduites sur un ensemble de disjoncteurs du commerce, de marques différentes. Une cartographie du champ magnétique émis par les disjoncteurs a été tracée pour chaque disjoncteur. On a découvert que tous les disjoncteurs étudiés présentent une paroi traversée par un champ magnétique et présentant un point de concentration du champ, où celui-ci est plus intense qu'en tout autre point du disjoncteur accessible de l'extérieur. Cette paroi est généralement la face avant des disjoncteurs, et le point de concentration se situe généralement à côté du levier de réarmement 21. Cette face avant est généralement appelée "petite face" car les disjoncteurs comportent généralement un boîtier comprenant une partie avant de faible volume et une partie arrière plus volumineuse, la face en question étant la face avant de la partie avant du boîtier, comme on le voit sur la figure 3.

Ces études montrent également que le champ magnétique Bi dans la zone de concentration comporte généralement une composante dominante. Avec certains modèles, il s'agit de la composante Bzi selon un axe Z perpendiculaire au plan de la face avant du disjoncteur, les composantes Bxi et Byi, selon des axes X et Y parallèles à la face avant, étant plus faibles. On en déduit que cette concentration de champ magnétique et plus particulièrement la présence d'une composante dominante est due à la présence de la bobine de protection.

Ainsi, selon un aspect de la présente invention, un magnétomètre numérique triaxial Mi du type mentionné plus haut est agencé sur la face avant du disjoncteur Di. Le magnétomètre Mi peut être utilisé sans modification, c'est-à-dire tel que vendu intégré dans un boîtier de faibles dimensions, ou être utilisé en tant que puce de semi-conducteur nue qui est montée dans un module de mesure décrit plus loin. Le magnétomètre Mi est utilisé pour détecter au moins une composante du champ magnétique présente sur la face avant du disjoncteur, de préférence la composante dominante, par exemple Bzi, et optionnellement les autres composantes Bxi, Byi de ce champ.

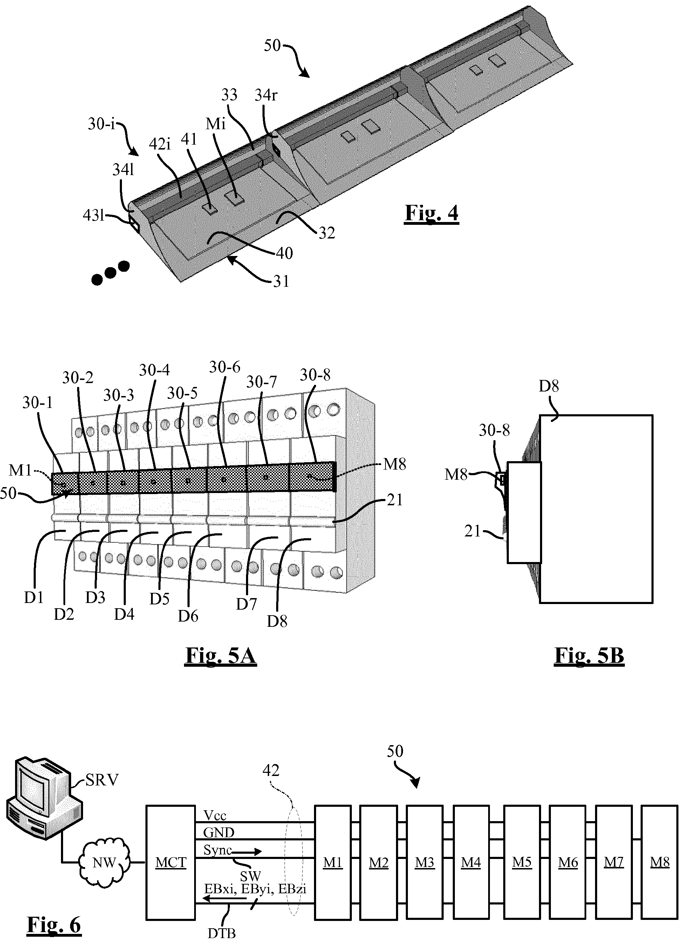

La figure 4 représente un dispositif 50 de mesure de courant selon l'invention. Le dispositif 50 comporte une pluralité de modules de mesure 30-1 identiques, agencés les uns à côté des autres. Chaque module 30-1 comporte un boîtier ouvert 31 comprenant un socle 32, un capot 33 s'étendant dans le prolongement du socle 32 et recouvrant partiellement celui-ci, une paroi latérale gauche 34l et une paroi latérale droite 34r. Un circuit imprimé 40 est agencé sur le socle 32. Le circuit imprimé 40 reçoit un magnétomètre numérique triaxial Mi du type décrit plus haut, les contacts du boîtier du magnétomètre étant soudés sur des plages de contact du circuit imprimé (non représentées). Alternativement, le magnétomètre Mi peut être monté en "puce nue" sur le circuit imprimé. Le circuit imprimé reçoit également des composants électroniques auxiliaires représentés schématiquement sous la forme d'un bloc 41, par exemple des condensateurs et des résistances.

Chaque module 30-1 comporte des pistes conductrices transversales 42-i, réalisées par exemple sur le circuit imprimé 40. Ces pistes transversales sont recouvertes par un cache de protection dans l'exemple représenté. Le magnétomètre Mi est relié électriquement aux pistes conductrices transversales 42-i par l'intermédiaire de pistes conductrices intermédiaires du circuit imprimé (non représentés). Les pistes conductrices transversales 42-i sont reliées électriquement à un connecteur gauche 43l et à un connecteur droit (non représenté) du module 30-1. Le connecteur gauche 43l traverse la paroi latérale gauche 34l et le connecteur droit traverse la paroi latérale droite 34r. Chaque connecteur 43l coopère ou peut coopérer électriquement avec le connecteur correspondant d'un module adjacent 30-(i+1) ou 30-(i-1), de manière que les pistes conductrices transversales 42-i des différents modules soient interconnectées et forment, ensemble, un bus de données et d'alimentation 42 auquel tous les magnétomètres Mi sont reliés.

Les figures 5A et 5B représentent, respectivement par une vue en perspective et de profil, un agencement du dispositif de mesure de courant 50 sur un ensemble de huit disjoncteurs magnétothermiques D1 à D8 agencés côte à côte, qui contrôlent les diverses branches d'un réseau électrique. Le dispositif 50 comprend ici huit modules 30-i (30-1 à 30-8) comprenant chacun un magnétomètre Mi, soit huit magnétomètres M1 à M8 au total. Comme on le voit sur la figure 5B, la face arrière du socle de chaque module 30-1i est fixée sur la face avant ("petite face") du disjoncteur correspondant Di, ici au-dessus du levier de réarmement 21, par exemple au moyen d'un adhésif double face. Chaque disjoncteur Di est donc associé à un magnétomètre Mi, qui permet de mesurer le champ magnétique émis par la bobine du disjoncteur.

La forme ouverte du boîtier de chaque module Mi est prévue ici pour permettre de passer le doigt au-dessus du circuit imprimé, pour le réarmement d'un disjoncteur, les modules 30-i étant agencés au-dessus du levier de réarmement 21. Dans ce cas, le levier 21, représenté sur la figure 5B en position basse, se trouve en effet dans une position haute et s'étend au-dessus du circuit imprimé du module Mi (M8).

La figure 6 est un schéma bloc de l'architecture électrique du dispositif 50. On distingue les huit magnétomètres M1 à M8 interconnectés par le bus de données et d'alimentation 42. Le bus 42 comprend un bus de données DTB incluant un fil d'horloge, un fil de synchronisation SW et des fils de masse GND et d'alimentation Vcc. Le fil de synchronisation SW permet d'appliquer aux magnétomètres un signal de synchronisation Sync, pour déclencher la mesure simultanée des champs magnétiques émis par les disjoncteurs. Le bus 42 permet de véhiculer des composantes échantillonnées EBxi, EByi, EBzi des champs magnétiques mesurés par les magnétomètres Mi.

Le dispositif 50 est relié par l'intermédiaire du bus 42 à un circuit de mesure et de contrôle MCT, par exemple un microcontrôleur. Le circuit MCT peut être logé dans un des modules de contrôle 30-i du dispositif 50 (Figure 4), qui forme alors à la fois un module de mesure et un module de contrôle des autres modules ("module maître"). Alternativement, un module de contrôle spécifique équipé du circuit MCT peut être prévu. Le module de contrôle est agencé en un point quelconque du tableau électrique, et est connecté au dispositif 50 par l'intermédiaire du connecteur gauche 43l du premier module 30-1 ou du connecteur droit du dernier module 30-8.

Le circuit MCT fournit le signal de synchronisation Sync et reçoit des échantillons d'au moins une composante des champs magnétiques mesurés par les magnétomètres Mi, par exemple des échantillons EBzi de la composante Bzi. Il peut également recevoir et traiter des échantillons EBxi, EByi des composantes Bxi, Byi, si une plus grande précision de mesure est visée.

Le circuit MCT applique une étape de traitement aux échantillons EBzi, ou aux échantillons des composantes Bxi, Byi, Bzi, pour supprimer de celles-ci une composante continue due au champ magnétique terrestre et calculer leur valeur efficace. La suppression de la composante continue est faite en calculant la valeur moyenne de tous les échantillons sur N échantillons, et en soustrayant cette valeur moyenne de la valeur de chaque échantillon. La valeur efficace des composantes, ou valeur RMS, est ensuite déterminée par le circuit MCT en calculant la racine carrée de la somme des échantillons au carré divisée par le nombre N1 d'échantillons, suivant la formule classique $\sqrt{[(1/N1)(\sum EBzi)]}$. Des algorithmes simplificateurs en soi connus peuvent être utilisés pour effectuer ce calcul de valeur efficace de façon simple, en économisant des ressources de calcul ou de la mémoire.

Dans ce qui suit, on désignera par "Bxi", "Byi", "Bzi" les valeurs efficaces des composantes portant la même référence, calculées comme cela vient d'être indiqué. Par "composante", on entendra cette valeur efficace, calculée à un instant donné à partir de plusieurs échantillons. Cette valeur efficace est recalculée régulièrement, pour obtenir plusieurs valeurs de la composante et suivre son évolution dans le temps pour la mise en oeuvre des étapes décrites ci-après.

Le circuit MCT applique ensuite à la composante Bzi ainsi calculée, ou aux composantes Bxi, Byi, Bzi ainsi calculées, une étape de traitement visant à neutraliser les effets d'un phénomène d'interférence magnétique entre disjoncteurs. Cette étape de traitement permet d'obtenir des composantes corrigées CBzi, ou des groupes de composantes corrigées CBxi, CByi, CBzi.

Le circuit MCT est également configuré pour transformer chaque composante corrigée CBzi, ou chaque groupe de composantes corrigées CBxi, CByi, CBzi, en une valeur de courant circulant dans le disjoncteur D1 associé au magnétomètre considéré Mi, soit la valeur du courant qui circule dans la branche du réseau électrique que le disjoncteur protège.

La transformation d'une composante corrigée CBzi en une valeur de courant est assurée au moyen de paramètres de conversion mémorisés par le circuit MCT, déterminés pendant une phase d'étalonnage. Cette phase d'étalonnage comprend par exemple, pour chaque disjoncteur :

- une étape d'ouverture de tous les disjoncteurs sauf celui devant être étalonné, qui est laissé dans l'état passant,
- une étape de mesure du courant dans la ligne électrique protégée par le disjoncteur; par tout moyen classique, ou d'estimation de ce courant en connectant la ligne à une charge électrique dont la consommation est connue,
- une étape de mesure de la composante Bzi du champ magnétique correspondant, au moyen du magnétomètre correspondant Mi, et
- une étape de mémorisation du courant I mesuré et de la composante Bzi, ou du rapport I/Bzi entre le courant mesuré et la composante Bzi.

Ces étapes d'étalonnage peuvent être répétées avec plusieurs valeurs de courant, pour plus de précision. Si le circuit MCT exploite également les composantes Bxi, Byi pour mesurer le courant, une étape d'étalonnage similaire est appliquée à celles-ci. Le circuit MCT obtient ensuite trois valeurs de courant à partir de chaque composante, et fait la moyenne de ces valeurs pour déterminer la valeur du courant, ou calcule le module du vecteur champ magnétique associé à ces trois composantes pour en déduire la valeur du courant.

Le circuit MCT comprend par ailleurs des moyens de communication, par exemple une interface de communication sans fil de type Wifi, pour établir une communication avec un dispositif central SRV de gestion de la consommation électrique. Le dispositif central SRV est par exemple un serveur ou un ordinateur individuel. Il peut être dédié à la gestion du réseau électrique considéré, ou d'un ensemble de réseaux électriques équipés de dispositif de mesure 50 selon l'invention. La communication entre le circuit MCT et le dispositif central est faite par l'intermédiaire d'un réseau informatique SW tel que le réseau Internet. Le dispositif central SRV gère une base de données qui contient la consommation électrique de chaque ligne du réseau électrique, et, de préférence, des appareils qui y sont connectés.

Des aspects de l'invention se rapportant à la neutralisation de l'effet d'interférence magnétique entre disjoncteurs seront maintenant exposés. Dans un souci de simplicité, on ne considérera que la suppression des interférences dans la composante Bzi, ce qui suit étant applicable aux deux autres composantes, lorsqu'elles sont exploitées par le circuit MCT.

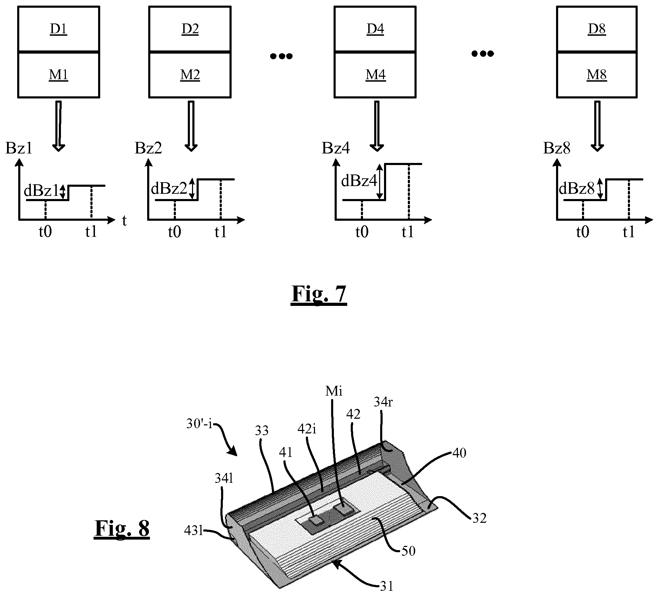

Comme illustré schématiquement sur la figure 7, considérons à titre d'exemple la rangée de 8 disjoncteurs D1 à D8 du dispositif 50, chacun étant équipé d'un magnétomètre Mi (M1 à M8). Chaque disjoncteur Di crée un champ magnétique qui est régit par la loi de Biot et Savard et s'étend sur une certaine distance, avec une décroissance en 1/d dans les 3 directions de détection, "d" étant la distance relativement à la bobine du disjoncteur. A un instant donné t0, sur réception du signal de synchronisation Sync envoyé par le circuit MCT, chaque magnétomètre Mi fournit la composante Bzi du champ magnétique émis par le disjoncteur correspondant Di. Cette composante Bzi est entachée d'une erreur causée par l'addition des champs magnétiques émis par les disjoncteurs voisins, s'ils sont traversés par du courant, et n'est donc plus proportionnelle au seul courant qui passe dans le disjoncteur Di.

L'homme de l'art peut définir des méthodes ou des algorithmes permettant de soustraire à la composante Bzi les effets de l'interférence. Une méthode consiste par exemple en un étalonnage avant la mise en service du dispositif : pour chaque disjoncteur Di, on mesure systématiquement, pour toute une gamme de valeurs de courants, l'interférence produit par le disjoncteur Di sur tous les disjoncteurs voisins. On forme ainsi une base de données qui est fournie au circuit MCT et utilisée par ce dernier pour corriger les composantes Bzi fournies par les magnétomètres Mi.

Selon un aspect optionnel de l'invention, le circuit MCT exécute un procédé de suppression d'interférence par apprentissage, ne nécessitant pas d'étalonnage. Ce procédé comprend une phase d'apprentissage et une phase d'exploitation.

Phase d'apprentissage :

i) le circuit MCT mesure les composantes Bzi (Bz1 à Bz8) à deux instants t0 et t1, et calcule la variation $dBzi = Bzi(t1) - Bzi(t0)$ de chaque composante Bzi.

ii) le circuit MCT recherche la plus forte variation dBzi en valeur absolue. Il s'agit par exemple de dBz4 dans l'exemple montré sur la figure 7.

iii) le circuit MCT attribue l'origine de la variation de chaque composant Bzi à une variation de courant dans le disjoncteur qui présente la plus forte variation de son champ magnétique, ici le disjoncteur D4, et suppose donc que le courant n'a pas varié dans les autres disjoncteurs (cette étape est implicite et sous-tend l'étape iv ci-après).

iv) le circuit MCT calcule, pour le disjoncteur D4, un paramètre d'interférence $P_{i,4}$ qui représente l'influence du disjoncteur D4 sur les magnétomètres Mi associés aux autres disjoncteurs, avec :

$$P_{i,4} = dBzi/dBz4$$

Pour le magnétomètre M4, ce paramètre est donc égal à 1.

v) le circuit MCT réitère les étapes i à iv au fur et à mesure des variations de courant dans les divers disjoncteurs, jusqu'à obtenir un paramètre d'interférence Pi,j de chaque disjoncteur de rang j sur chaque magnétomètre de rang i, soit :

$$Pi,j = dBzi/dBzj$$

pour i allant ici de 1 à 8 et j allant de 1 à 8. Chaque calcul est comme précédemment basé sur la détection de la plus grande variation mesurée dBz en valeur absolue. Chaque paramètre d'interférence Pi,j peut être calculé plusieurs fois et ensuite moyenné, pour obtenir une valeur plus précise.

vi) Au terme de l'étape d'apprentissage, le circuit MCT obtient un ensemble de vecteurs d'interférence VINTi. Chaque vecteur d'interférence VINTi est associé à un disjoncteur Di et comprend les paramètres d'interférence de ce disjoncteur sur les magnétomètres associés aux autres disjoncteurs. Par exemple, pour le disjoncteur D4, le vecteur d'interférence VINT4 est égal à :

$$VINT4 = \{dBz1/dBz4, \ dBz2/dBz4, \ dBz3/dBz4, \ 1, \ dBz5/dBz4, \ dBz6/dBz4, \ dBz7/dBz4, \ dBz8/dBz4\}$$

Soit :

$$VINT4 = \{P_{1,4},\ P_{2,4},\ P_{3,4},\ 1,\ P_{5,4},\ P_{6,4},\ P_{7,4},\ P_{8,4}\}$$

Le circuit MCT détermine ensuite la matrice d'interférence "MINT" montrée ci-après, en associant à chaque colonne de la matrice un vecteur d'interférence VINTi. Le vecteur VINT1 forme la première colonne de la matrice, le vecteur VINT2 la deuxième colonne, etc.

Matrice MINT :

| 1 | dBz1/dBz2 | dBz1/dBz3 | dBz1/dBz4 | dBz1/dBz5 | dBz1/dBz6 | dBz1/dBz7 | dBz1/dBz8 |
|---|---|---|---|---|---|---|---|
| dBz2/dBz1 | 1 | dBz2/dBz3 | dBz2/dBz4 | dBz2/dBz5 | dBz2/dBz6 | dBz2/dBz7 | dBz2/dBz8 |
| dBz3/dBz1 | dBz3/dBz2 | 1 | dBz3/dBz4 | dBz3/dBz5 | dBz3/dBz6 | dBz3/dBz7 | dBz3/dBz8 |
| dBz4/dBz1 | dBz4/dBz2 | dBz4/dBz3 | 1 | dBz4/dBz5 | dBz4/dBz6 | dBz4/dBz7 | dBz4/dBz8 |
| dBz5/dBz1 | dBz5/dBz2 | dBz5/dBz3 | dBz5/dBz4 | 1 | dBz5/dBz6 | dBz5/dBz7 | dBz5/dBz8 |
| dBz6/dBz1 | dBz6/dBz2 | dBz6/dBz3 | dBz6/dBz4 | dBz6/dBz5 | 1 | dBz6/dBz7 | dBz6/dBz8 |
| dBz7/dBz1 | dBz7/dBz2 | dBz7/dBz3 | dBz7/dBz4 | dBz7/dBz5 | dBz7/dBz6 | 1 | dBz7/dBz8 |
| dBz8/dBz1 | dBz8/dBz2 | dBz8/dBz3 | dBz8/dBz4 | dBz8/dBz5 | dBz8/dBz6 | dBz8/dBz7 | 1 |

La matrice MINT obtenue au cours de la phase d'apprentissage peut être imparfaite. L'apprentissage peut donc se poursuivre pendant la phase d'exploitation, pour affiner les paramètres d'interférence. Ainsi, la phase d'apprentissage peut être superposée à la phase d'exploitation. Un critère d'arrêt de la phase d'apprentissage peut être prévu, par exemple lorsque chacun des paramètres d'interférence calculés se stabilise au voisinage d'une valeur moyenne.

Phase d'exploitation :

La phase d'exploitation repose sur le raisonnement suivant :

1) Soit M un vecteur des mesures magnétiques vraies, c'est-à-dire entachées d'interférences, comprenant l'ensemble des composantes Bzi :

$$M = \{Bz1,\ Bz2,\ Bz3,\ Bz4,\ Bz5,\ Bz6,\ Bz7,\ Bz8\}$$

2) Soit S un vecteur de mesures magnétiques sans interférence, comprenant des composantes CBzi qui seraient mesurées s'il n'y avait pas d'interférence :

$$S = \{CBz1,\ CBz2,\ CBz3,\ CBz4,\ CBz5,\ CBz6,\ CBz7,\ CBz8\}$$

On peut écrire :

$$M = MINT\ x\ S$$

A cet effet, on suppose que la matrice MINT ne dépend que de la topologie des disjoncteurs et non pas des courants qui y circulent. L'homme de l'art reconnaîtra dans cette hypothèse le fait que les champs ne sont pas couplés d'un disjoncteur à l'autre. Cette hypothèse a été vérifiée par des mesures en laboratoire.

En d'autres termes, le vecteur des mesures magnétiques vraies M est égal au produit du vecteur des mesures magnétiques sans interférence S par la matrice d'interférence MINT. Cela signifie que chaque composante Bzi mesurée sur un disjoncteur Di est égale à la composante sans interférence CBzi du disjoncteur à laquelle on ajoute la somme des interférences, soit la somme des produits de chaque paramètre d'interférence dBzi/dBzj par les valeurs de la composante correspondante sans interférence CBzj mesurée sur un autre disjoncteur, soit par exemple :

```
Bz1=  CBz1  +  CBz2*dBz1/dBz2  +  CBz3*dBz1/dBz3  +  CBz4*dBz1/dBz4  +

CBz5*dBz1/dBz5 + CBz6*dBz1/dBz6 + CBz7*dBz1/dBz7 + CBz8*dBz1/dBz8
```

Il est donc possible d'écrire :

$$S = \text{MINT}^{-1} \times M$$

$\text{MINT}^{-1}$ étant la matrice inversée de M.

Ainsi, au cours de la phase d'exploitation, le circuit MCT calcule la matrice inversée $\text{MINT}^{-1}$ et l'utilise pour transformer le vecteur de mesures magnétiques vraies M en vecteur de mesures magnétiques sans interférence S. Le calcul du vecteur S fournit au circuit MCT les valeurs corrigées CBzi des composantes mesurées Bzi, à partir desquelles il en déduit la valeur du courant traversant chaque disjoncteur.

La matrice MINT pouvant être mal conditionnée, son inversion peut être calculée en faisant appel à des méthodes telles que la méthode des pseudo-inverses, ou encore des méthodes de type SVD ("Singular Value Décomposition" ou "décomposition par valeur singulière") qui permettent d'obtenir une valeur exacte ou approchée de la matrice inverse $\text{MINT}^{-1}$. On entend par "mal conditionnée" le fait que la matrice peut être entachée d'incertitudes de mesures. Dans ce cas, le calcul de la matrice inverse peut faire apparaître des rapports de valeurs très faibles produisant des valeurs aléatoires. La méthode SVD, par exemple, consiste à mettre les valeurs faibles à 0 et à former une matrice pseudo-inverse qui prend en compte les valeurs nulles, cette méthode étant bien connue de l'homme de l'art.

Également il apparaîtra clairement à l'homme de l'art que le calcul du vecteur S effectué au moyen de la matrice inverse $\text{MINT}^{-1}$ est susceptible d'être effectué suivant diverses autres méthodes mathématiques ou algorithmes de calcul, la matrice n'étant qu'un simple outil mathématique. Par exemple une méthode utilisant des algorithmes neuronaux pourrait être mise en oeuvre.

Ce calcul permet de soustraire de chaque composante mesurée Bzi la somme des produits des autres composantes Bzi par leurs paramètres d'interférence respectifs, pour obtenir la composante corrigée CBzi. En effet, si l'on désigne par $C_{i,j}$ les termes de la matrice inverse, on peut écrire que :

$$CBzi = \sum_{(j=1 \to N2)} C_{i,j} * Bzj$$

avec j allant de 1 à N2, N2 étant le nombre de disjoncteurs, et i le rang du disjoncteur considéré.

Ainsi, les composantes corrigées CBzi s'obtiennent chacune comme une combinaison linéaire des composantes mesurées Bzj, pour j variant de 1 à N2. Les coefficients de ces combinaisons linéaires sont généralement négatifs pour les champs qui présentent toujours la même orientation, sauf à concevoir le cas où les courants seraient déphasés de 180° d'un disjoncteur à l'autre sous l'effet d'une charge capacitive pure, ce qui apparaît comme étant impossible en pratique.

Le procédé qui vient d'être décrit peut optionnellement être également appliqué aux composantes Bxi, Byi, pour une mesure de champ plus précise, notamment dans des applications où les disjoncteurs présentent une composante Bzi qui n'est pas nettement supérieure aux composantes Bxi et Byi. De même, s'il advient que certains modèles de disjoncteurs présentent une composante Bxi ou Byi supérieure aux deux autres, cette composante peut être utilisée préférentiellement à la place de la composante Bzi, s'il n'est pas souhaité d'utiliser les trois composantes. Deux composantes sur trois pourraient également être utilisées, au lieu d'une seule ou des trois à la fois.

Il apparaîtra clairement à l'homme de l'art que la présente invention et susceptible de diverses autres variantes et modes de réalisation.

Notamment, il n'est pas exclu qu'il puisse exister sur le marché des modèles de disjoncteurs ayant un point de concentration du champ magnétique situé en un autre point qu'à proximité du le levier de réarmement, par exemple sur une autre paroi du disjoncteur. Dans ce cas, des modules selon l'invention pourraient avoir une autre forme que celle montrée sur les dessins.

Également, un module de mesure 30-i selon l'invention peut être utilisé seul pour mesurer le courant dans une seule ligne d'un réseau électrique. Dans ce cas, il peut arriver que le module 30-i soit agencé sur un disjoncteur environné d'autres disjoncteurs. Ces autres disjoncteurs peuvent perturber la mesure faite au moyen du magnétomètre M, par effet d'interférence. Dans ce cas, la méthode de correction décrite plus haut ne peut pas être mise en oeuvre, ni même une méthode de correction par étalonnage, puisque l'on ne connaît pas en temps réel la valeur du courant passant dans les autres disjoncteurs.

Un mode de réalisation 30'-i du module, représenté sur la figure 8, peut être utilisé dans ce cas. Le module 30'-i se distingue du module 30-i en ce qu'il comporte, autour du magnétomètre Mi, un blindage magnétique 50 réalisé en un métal présentant de préférence une bonne perméabilité magnétique. Le blindage 50 entoure le magnétomètre Mi et laisse donc passer la composante Bzi perpendiculaire au socle 31 du module 30'-i, qui est émise par le disjoncteur sur lequel le module 30'-1 est agencé, tout en bloquant les composantes Bxi et Byi émises par les autres disjoncteurs, qui se propagent parallèlement au socle 31.

Le module 30'-i peut également être utilisé pour réaliser le dispositif 50 montré sur la figure 4. Dans ce cas, le phénomène d'interférence est fortement atténué grâce au blindage que chaque module comporte. Il peut alors n'être plus nécessaire de calculer des composantes corrigées CBzi, les composantes Bzi pouvant être exploitées par le circuit MCT sans correction après suppression de la composante continue du champ magnétique terrestre. Dans une variante, on combine la prévision du blindage magnétique et du procédé de correction des composantes Bzi, pour une mesure encore plus précise.

**Revendications**

1. Procédé de mesure de courant dans un réseau électrique, comprenant au moins une première ligne électrique, **caractérisé en ce qu'**il comprend les étapes consistant à :

   - relier la première ligne électrique à un premier disjoncteur (Di) comprenant une première bobine de protection (22) et présentant une paroi traversée par un champ magnétique (Bi, Bxi, Byi, Bzi) émis par la bobine,
   - agencer sur la paroi du premier disjoncteur un premier magnétomètre numérique triaxial synchrone (Mi) sur microplaquette de semi-conducteur,
   - au moyen du premier magnétomètre numérique (Mi), mesurer au moins une composante (Bzi) du champ magnétique émis par la première bobine, et
   - déterminer la valeur d'un courant traversant la ligne électrique à partir de la composante mesurée.

2. Procédé selon la revendication 1, comprenant une étape consistant à agencer autour du magnétomètre (Mi) un blindage magnétique (50) pour limiter l'influence sur le magnétomètre d'un champ magnétique émis par un disjoncteur voisin.

3. Procédé selon la revendication 1, comprenant les étapes consistant à :

   - relier au moins une seconde ligne électrique à un second disjoncteur (Di) comprenant une seconde bobine de protection (22) présentant une paroi traversée par un champ magnétique (Bxi, Byi, Bzi) émis par la seconde bobine,
   - agencer sur la paroi du second disjoncteur un second magnétomètre numérique triaxial synchrone (Mi) sur microplaquette de semi-conducteur,
   - au moyen du second magnétomètre (Mi), mesurer au moins une composante (Bzi) d'un champ magnétique émis par la première bobine,
   - corriger les composantes (Bzi) mesurées par chaque magnétomètre en retranchant à chaque composante une fraction de la composante mesurée par l'autre magnétomètre, afin de neutraliser un phénomène d'interférence magnétique entre les deux disjoncteurs, et
   - déterminer la valeur d'un courant traversant chaque ligne électrique à partir des composantes corrigées.

4. Procédé selon la revendication 3, dans lequel l'étape de correction comprend une étape de détermination, pour chaque disjoncteur, d'un paramètre d'interférence du disjoncteur sur un magnétomètre associé à un autre disjoncteur, représentatif d'une variation (dBz1) du champ magnétique détecté par le magnétomètre associé à l'autre disjoncteur, lorsque le champ magnétique émis par le disjoncteur varie (dBz4).

5. Procédé selon la revendication 4, comprenant une étape de détermination d'une matrice d'interférence incluant l'ensemble des paramètres d'interférence, une étape de détermination d'une matrice inverse de la matrice d'interférence, et une étape de correction des composantes mesurées (Bz) à partir de la matrice d'interférence inversée.

6. Procédé selon l'une des revendications 4 et 5, dans lequel l'étape de détermination du paramètre d'interférence comprend les étapes suivantes :

   - échantillonner de manière synchrone, à deux instants successifs, une composante (Bzi) du champ magnétique mesurée par le premier magnétomètre et une composante du champ magnétique mesurée par le second magnétomètre,
   - déterminer une variation de la première composante et une variation de la seconde composante, et
   - déterminer le paramètre d'interférence d'un disjoncteur sur le magnétomètre associé à l'autre disjoncteur en divisant la plus petite des deux variations en valeur absolue par la plus grande des deux variations en valeur absolue.

**7.** Procédé selon l'une des revendications 1 à 6, comprenant une étape d'étalonnage de chaque magnétomètre pour associer à une valeur de champ magnétique alternatif mesurée une valeur de courant circulant dans la ligne électrique correspondante.

**8.** Procédé selon l'une des revendications 1 à 7, dans lequel la mesure d'une composante d'un champ magnétique émis par la bobine d'un disjoncteur comprend une étape de suppression d'une composante continue de champ magnétique terrestre.

**9.** Dispositif de mesure de courant dans un réseau électrique, **caractérisé en ce qu'**il comprend :

- au moins un premier disjoncteur (Di) relié à une première ligne électrique, comprenant une première bobine de protection (22) et présentant une paroi traversée par un champ magnétique (Bi, Bxi, Byi, Bzi) émis par la bobine,
- un premier magnétomètre numérique triaxial synchrone (Mi) sur microplaquette de semi-conducteur, agencé sur la paroi du premier disjoncteur, et
- un circuit de contrôle et de traitement (MCT), pour mesurer au moyen du premier magnétomètre au moins une composante (Bzi) du champ magnétique émis par la première bobine, et déterminer la valeur d'un courant traversant la ligne électrique à partir de la composante mesurée.

**10.** Dispositif selon la revendication 9, comprenant un blindage magnétique (50) agencé autour du magnétomètre (Mi) pour limiter l'influence sur le magnétomètre d'un champ magnétique émis par un disjoncteur voisin.

**11.** Dispositif selon l'une des revendications 9 et 10, comprenant

- au moins un second disjoncteur (Di) relié à une seconde ligne électrique, comprenant une seconde bobine de protection (22) et présentant une paroi traversée par un champ magnétique (Bxi, Byi, Bzi) émis par la seconde bobine,
- un second magnétomètre numérique triaxial synchrone (Mi) sur microplaquette de semi-conducteur, agencé sur la paroi du second disjoncteur, et relié au circuit de contrôle et de traitement (MCT),

dans lequel le circuit de contrôle et de traitement (MCT) est configuré pour corriger les composantes (Bzi) mesurées par chaque magnétomètre en retranchant à chaque composante une fraction de la composante mesurée par l'autre magnétomètre, afin de neutraliser un phénomène d'interférence magnétique entre les deux disjoncteurs, et déterminer la valeur d'un courant traversant chaque ligne électrique à partir des composantes corrigées.

**12.** Dispositif selon la revendication 11, dans lequel le circuit de contrôle et de traitement (MCT) est configuré pour déterminer, pour chaque disjoncteur, un paramètre d'interférence du disjoncteur sur un magnétomètre associé à un autre disjoncteur, représentatif d'une variation (dBz1) du champ magnétique détecté par le magnétomètre associé à l'autre disjoncteur, lorsque le champ magnétique émis par le disjoncteur varie (dBz4).

**13.** Dispositif selon la revendication 12, dans lequel le circuit de contrôle et de traitement (MCT) est configuré pour :

- échantillonner de manière synchrone, à deux instants successifs, une composante (Bzi) du champ magnétique mesurée par le premier magnétomètre et une composante du champ magnétique mesurée par le second magnétomètre,
- déterminer une variation de la première composante et une variation de la seconde composante, et
- déterminer le paramètre d'interférence d'un disjoncteur sur le magnétomètre associé à l'autre disjoncteur en divisant la plus petite en valeur absolue des deux variations par la plus grande des deux variations en valeur absolue.

**14.** Dispositif de mesure selon l'une des revendications 9 à 13, comprenant un module de mesure (30-i) comprenant un boîtier (31) configuré pour être agencé sur la paroi d'un disjoncteur, un support d'interconnexion (40) recevant un magnétomètre (Mi), et des moyens (42i, 431) de couplage électrique du magnétomètre à au moins un autre magnétomètre agencé dans un autre module de mesure.

**15.** Système de gestion de la consommation électrique dans un réseau électrique comprenant des lignes électriques, **caractérisé en ce qu'**il comprend un dispositif de mesure selon l'une des revendications 9 à 14, et un dispositif de gestion déporté (SRV) configuré pour mémoriser des valeurs de courant fournies par le dispositif de mesure.

**Patentansprüche**

1. Verfahren zur Strommessung in einem Stromnetz, das mindestens eine erste Stromleitung umfasst, **dadurch gekennzeichnet, dass** es die Schritte umfasst, die darin bestehen:

   - die erste Stromleitung mit einem ersten Schutzschalter (Di) zu verbinden, der eine erste Schutzspule (22) umfasst und eine Wand aufweist, die von einem von der Spule abgestrahlten Magnetfeld (Bi, Bxi, Byi, Bzi) durchquert wird,
   - ein erstes digitales, synchron messendes 3-Achsen-Magnetometer (Mi) auf einem Halbleiterchip an der Wand des ersten Schutzschalters anzuordnen,
   - mittels des ersten Digitalmagnetometers (Mi) mindestens eine Komponente (Bzi) des von der ersten Spule abgestrahlten Magnetfelds zu messen und
   - den Wert des Stroms, der die Stromleitung durchfließt, anhand der gemessenen Komponente zu bestimmen.

2. Verfahren nach Anspruch 1, das einen Schritt umfasst, der darin besteht, um das Magnetometer (Mi) herum eine magnetische Abschirmung (50) anzuordnen, um den Einfluss eines Magnetfelds, das von einem benachbarten Schutzschalter abgestrahlt wird, auf das Magnetometer einzuschränken.

3. Verfahren nach Anspruch 1, das die Schritte umfasst, die darin bestehen:

   - mindestens eine zweite Stromleitung mit einem zweiten Schutzschalter (Di) zu verbinden, der eine zweite Schutzspule (22) umfasst, die eine Wand aufweist, die von einem von der zweiten Spule abgestrahlten Magnetfeld (Bxi, Byi, Bzi) durchquert wird,
   - eine zweites digitales, synchron messendes 3-Achsen-Magnetometer (Mi) auf einem Halbleiterchip an der Wand des zweiten Schutzschalters anzuordnen,
   - mittels des zweiten Magnetometers (Mi) mindestens eine Komponente (Bzi) des von der ersten Spule abgestrahlten Magnetfelds zu messen,
   - die Komponenten (Bzi), die von jedem Magnetometer gemessen wurden, zu korrigieren, indem von jeder Komponente der Anteil der von dem anderen Magnetometer gemessenen Komponente subtrahiert wird, um störende magnetische Wechselwirkungen zwischen den beiden Schutzschaltern zu neutralisieren, und
   - den Wert des Stroms, der jede Stromleitung durchfließt, anhand der korrigierten Komponenten zu bestimmen.

4. Verfahren nach Anspruch 3, wobei der Korrekturschritt einen Schritt umfasst, bei dem für jeden Schutzschalter ein Parameter für den Störeinfluss des Schutzschalters auf ein einem anderen Schutzschalter zugeordnetes Magnetometer bestimmt wird, der repräsentativ für eine Änderung (dBz1) des Magnetfelds ist, das von dem dem anderen Schutzschalter zugeordneten Magnetometer erfasst wird, wenn sich das von dem Schutzschalter abgestrahlte Magnetfeld ändert (dBz4).

5. Verfahren nach Anspruch 4, umfassend einen Schritt zur Bestimmung einer Störmatrix, die die Gesamtheit der Störparameter enthält, einen Schritt zur Bestimmung einer zu der Störmatrix inversen Matrix und einen Schritt zur Korrektur der gemessenen Komponenten (Bz) anhand der inversen Störmatrix.

6. Verfahren nach einem der Ansprüche 4 und 5, wobei der Schritt zur Bestimmung des Störparameters die folgenden Schritte umfasst:

   - synchrones Abtasten, zu zwei aufeinanderfolgenden Zeitpunkten, einer Komponente (Bzi) des vom ersten Magnetometer gemessenen Magnetfelds und einer Komponente des vom zweiten Magnetometer gemessenen Magnetfelds,
   - Bestimmen einer Änderung der ersten Komponente und einer Änderung der zweiten Komponente, und
   - Bestimmen des Parameters des Störeinflusses eines Schutzschalters auf das dem anderen Schutzschalter zugeordnete Magnetometer, durch Teilen der kleinsten der beiden Änderungen, ausgedrückt als Absolutwert, durch die größte der beiden Änderungen, ausgedrückt als Absolutwert.

7. Verfahren nach einem der Ansprüche 1 bis 6, umfassend einen Schritt zur Kalibrierung jedes Magnetometers, um einem gemessenen Wert eines magnetischen Wechselfelds einen Wert des in der entsprechenden Stromleitung fließenden Stroms zuzuordnen.

8. Verfahren nach einem der Ansprüche 1 bis 7, wobei die Messung einer Komponente eines von der Spule eines Schutzschalters abgestrahlten Magnetfelds einen Schritt zur Unterdrückung einer Gleichkomponente des Erdmagnetfelds umfasst.

9. Vorrichtung zur Strommessung in einem Stromnetz, **dadurch gekennzeichnet, dass** sie umfasst:

- mindestens einen ersten Schutzschalter (Di), der mit einer ersten Stromleitung verbunden ist, eine erste Schutzspule (22) umfasst und eine Wand aufweist, die von einem von der Spule abgestrahlten Magnetfeld (Bi, Bxi, Byi, Bzi) durchquert wird,
- ein erstes digitales, synchron messendes 3-Achsen-Magnetometer (Mi) auf einem Halbleiterchip, das an der Wand des ersten Schutzschalters angeordnet ist, und
- eine Steuer- und Verarbeitungsschaltung (MCT), um mittels des ersten Magnetometers (Mi) mindestens eine Komponente (Bzi) des von der ersten Spule abgestrahlten Magnetfelds zu messen und anhand der gemessenen Komponente den Wert des Stroms zu bestimmen, der die Stromleitung durchfließt.

10. Vorrichtung nach Anspruch 9, umfassend eine magnetische Abschirmung (50), die um das Magnetometer (Mi) herum angeordnet ist, um den Einfluss eines Magnetfelds, das von einem benachbarten Schutzschalter abgestrahlt wird, auf das Magnetometer einzuschränken.

11. Vorrichtung nach einem der Ansprüche 9 und 10, umfassend:

- mindestens einen zweiten Schutzschalter (Di), der mit einer zweiten Stromleitung verbunden ist, eine zweite Schutzspule (22) umfasst und eine Wand aufweist, die von einem von der zweiten Spule abgestrahlten Magnetfeld (Bxi, Byi, Bzi) durchquert wird,
- ein zweites digitales, synchron messendes 3-Achsen-Magnetometer (Mi) auf einem Halbleiterchip, das an der Wand des zweiten Schutzschalters angeordnet ist und mit der Steuer- und Verarbeitungsschaltung (MCT) verbunden ist,

wobei die Steuer- und Verarbeitungsschaltung (MCT) dazu ausgestaltet ist, die von jedem Magnetometer gemessenen Komponenten (Bzi) zu korrigieren, indem von jeder Komponente der Anteil der von dem anderen Magnetometer gemessenen Komponente subtrahiert wird, um störende magnetische Wechselwirkungen zwischen den beiden Schutzschaltern zu neutralisieren, und den Wert des Stroms, der jede Stromleitung durchfließt, anhand der korrigierten Komponenten zu bestimmen.

12. Vorrichtung nach Anspruch 11, wobei die Steuer- und Verarbeitungsschaltung (MCT) dazu ausgestaltet ist, für jeden Schutzschalter einen Parameter für den Störeinfluss des Schutzschalters auf ein einem anderen Schutzschalter zugeordnetes Magnetometer zu bestimmen, der repräsentativ für eine Änderung (dBz1) des Magnetfelds ist, das von dem dem anderen Schutzschalter zugeordneten Magnetometer erfasst wird, wenn sich das von dem Schutzschalter abgestrahlte Magnetfeld ändert (dBz4).

13. Vorrichtung nach Anspruch 12, wobei die Steuer- und Verarbeitungsschaltung (MCT) dazu ausgestaltet ist:

- synchron, zu zwei aufeinanderfolgenden Zeitpunkten, eine Komponente (Bzi) des vom ersten Magnetometer gemessenen Magnetfelds und eine Komponente des vom zweiten Magnetometer gemessenen Magnetfelds abzutasten,
- eine Änderung der ersten Komponente und eine Änderung der zweiten Komponente zu bestimmen, und
- den Parameter der Störeinflusses eines Schutzschalters auf das dem anderen Schutzschalter zugeordnete Magnetometer durch Teilen der kleinsten der beiden Änderungen, ausgedrückt als Absolutwert, durch die größte der beiden Änderungen, ausgedrückt als Absolutwert, zu bestimmen.

14. Messvorrichtung nach einem der Ansprüche 9 bis 13, umfassend ein Messmodul (30-i) mit einer Einhausung (31), die zur Anordnung an der Wand eines Schutzschalters ausgestaltet ist, einen Schaltungsträger (40), der ein Magnetometer (Mi) aufnimmt, und Mittel (42i, 431) zur elektrischen Kopplung des Magnetometers mit mindestens einem anderen Magnetometer, das in einem anderen Messmodul angeordnet ist.

15. System zur Verwaltung des Stromverbrauchs in einem Stromnetz, das Stromleitungen umfasst, **dadurch gekennzeichnet, dass** es eine Messvorrichtung nach einem der Ansprüche 9 bis 14 und eine Fernverwaltungsvorrichtung (SRV), die dazu ausgestaltet ist, von der Messvorrichtung gelieferte Stromwerte zu speichern, umfasst.

## EP 2 637 027 B1

**Claims**

1. A method for measuring current in an electric network, comprising at least one first electric line, **characterized in that** it comprises the steps of:

   - linking the first electric line to a first circuit breaker (Di) comprising a first protection coil (22) and having a wall traversed by a magnetic field (Bi, Bxi, Byi, Bzi) emitted by the coil;
   - arranging, on the wall of the first circuit breaker, a first synchronous three-axis digital magnetometer (Mi) on a semiconductor chip;
   - measuring, by means of the first digital magnetometer (Mi), at least one component (Bzi) of the magnetic field emitted by the first coil; and
   - determining, from the measured component, the value of a current traversing the electric line.

2. Method according to claim 1, comprising a step of arranging a magnetic shield (50) around the magnetometer (Mi) to limit the influence on the magnetometer of a magnetic field emitted by a neighboring circuit breaker.

3. Method according to claim 1, comprising the steps of:

   - linking at least one second electric line to a second circuit breaker (Di) comprising a second protection coil (22) having a wall traversed by a magnetic field (Bxi, Byi, Bzi) emitted by the second coil;
   - arranging, on the wall of the second circuit breaker, a second synchronous three-axis digital magnetometer (Mi) on a semiconductor chip;
   - measuring, by means of the second magnetometer (Mi), at least one component (Bzi) of a magnetic field emitted by the first coil;
   - correcting the components (Bzi) measured by each magnetometer by subtracting from each component a fraction of the component measured by the other magnetometer, so as to neutralize a phenomenon of magnetic interference between the two circuit breakers; and
   - determining the value of a current traversing each electric line from the corrected components.

4. Method according to claim 3, wherein the correction step comprises a step of determining, for each circuit breaker, an interference parameter of the circuit breaker on a magnetometer associated with another circuit breaker, representative of a variation (dBz1) in the magnetic field detected by the magnetometer associated with the other circuit breaker, when the magnetic field emitted by the circuit breaker varies (dBz4).

5. Method according to claim 4, comprising a step of determining an interference matrix including all the interference parameters, a step of determining an inverse matrix of the interference matrix, and a step of correcting the components measured (Bz) from the inverse interference matrix.

6. Method according to one of claims 4 and 5, wherein the step of determining the interference parameter comprises the following steps:

   - sampling in a synchronous manner, at two successive times, a component (Bzi) of the magnetic field measured by the first magnetometer and a component of the magnetic field measured by the second magnetometer;
   - determining a variation in the first component and a variation in the second component; and
   - determining the interference parameter of a circuit breaker on the magnetometer associated with the other circuit breaker by dividing the smallest of the two variations in absolute value by the highest of the two variations in absolute value.

7. Method according to one of claims 1 to 6, comprising a step of calibrating each magnetometer to associate a value of current circulating in the corresponding electric line with a measured alternating magnetic field value.

8. Method according to one of claims 1 to 7, wherein the measurement of a component of a magnetic field emitted by the coil of a circuit breaker comprises a step of removing a DC offset of terrestrial magnetic field.

9. A device for measuring current in an electric network, **characterized in that** it comprises:

   - at least one first circuit breaker (Di) linked to a first electric line, comprising a first protection coil (22) and having a wall traversed by a magnetic field (Bi, Bxi, Byi, Bzi) emitted by the coil;

14

- a first synchronous three-axis digital magnetometer (Mi) on a semiconductor chip, arranged on the wall of the first circuit breaker; and
- a monitoring and processing circuit (MCT), for measuring by means of the first magnetometer at least one component (Bzi) of the magnetic field emitted by the first coil, and determining the value of a current traversing the electric line from the measured component.

10. Device according to claim 9, comprising a magnetic shield (50) arranged around the magnetometer (Mi) to limit the influence on the magnetometer of a magnetic field emitted by a neighboring circuit breaker.

11. Device according to one of claims 9 and 10, comprising:

- at least one second circuit breaker (Di) linked to a second electric line, comprising a second protection coil (22) and having a wall traversed by a magnetic field (Bxi, Byi, Bzi) emitted by the second coil;
- a second synchronous three-axis digital magnetometer (Mi) on a semiconductor chip, arranged on the wall of the second circuit breaker, and linked to the monitoring and processing circuit (MCT);

wherein the monitoring and processing circuit (MCT) is configured to correct the components (Bzi) measured by each magnetometer by subtracting from each component a fraction of the component measured by the other magnetometer, so as to neutralize a phenomenon of magnetic interference between the two circuit breakers, and to determine the value of a current traversing each electric line from the corrected components.

12. Device according to claim 11, wherein the monitoring and processing circuit (MCT) is configured to determine, for each circuit breaker, an interference parameter of the circuit breaker on a magnetometer associated with another circuit breaker, representative of a variation (dBz1) in the magnetic field detected by the magnetometer associated with the other circuit breaker, when the magnetic field emitted by the circuit breaker varies (dBz4) .

13. Device according to claim 12, wherein the monitoring and processing circuit (MCT) is configured to:

- sample in a synchronous manner, at two successive times, a component (Bzi) of the magnetic field measured by the first magnetometer and a component of the magnetic field measured by the second magnetometer;
- determine a variation in the first component and a variation in the second component; and
- determine the interference parameter of a circuit breaker on the magnetometer associated with the other circuit breaker by dividing the smallest of the two variations in absolute value by the highest of the two variations in absolute value.

14. A measuring device according to one of claims 9 to 13, comprising a measurement module (30-i) comprising a housing (31) configured to be arranged on the wall of a circuit breaker, an interconnect carrier (40) receiving a magnetometer (Mi), and means (42i, 431) for electrically coupling the magnetometer to at least one other magnetometer arranged in another measurement module.

15. A system for managing current consumption in an electric network comprising electric lines, **characterized in that** it comprises a measuring device according to one of claims 9 to 14, and a remote management device (SRV) configured to store values of current supplied by the measuring device.

Mi

X

Y

Z

**Fig. 1**
**Art Antérieur**

Mi

| XDET | Cxi |
| YDET | Cyi |
| ZDET | Czi |

MUX ⟷ ADC ⟷ DSPCT

Vcc
GND
SIN

Bxi, Byi, Bzi

DTB

**Fig. 2**
**Art Antérieur**

Di

Bi

Mi

Bz

By

Bx

21

22

**Fig. 3**

**Fig. 4**

**Fig. 5A**

**Fig. 5B**

**Fig. 6**

| D1 | | D2 | | | D4 | | | D8 |
|:--:|:--:|:--:|:--:|:--:|:--:|:--:|:--:|:--:|
| M1 | | M2 | ●●● | | M4 | | ●●● | M8 |

Bz1　　　　　　Bz2　　　　　　　Bz4　　　　　　　Bz8

dBz1　　　　　dBz2　　　　　　dBz4　　　　　　dBz8

t0　　t1　　t　　t0　　t1　　　t0　　t1　　　t0　　t1

## Fig. 7

**Fig. 8**

30'-i　　33　42i　Mi　42　34r
　　41　　　　　　　　　40
341　　　　　　　　　　　32
431　　　　　　　　50
　　　　　　　　　31

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- WO 2012003492 A
- WO 2008042483 A
- WO 0150142 A